# DEMANDE DE BREVET EUROPEEN

(11) **EP 2 913 710 A1**
(43) Date de publication de la demande: **02.09.2015**
(21) Numéro de dépôt: 14157240.4
(22) Date de dépôt: 28.02.2014
(51) Int. Cl.: G03F 7/00, G03F 7/40

(54) **Méthode de fabrication par photolithographie et électroformage de pièces métalliques comportant des éléments rapportés**

(71) Demandeur: Mimotec S.A., 1950 Sion (CH)
(72) Inventeur: Genolet, Grégoire, 1926 Fully (CH); Bagnoud, Thomas, 1950 Sion (CH); Lorenz, Hubert, 1965 Savièse (CH)
(74) Mandataire: Leman Consulting S.A.

(57) **Abrégé**

Un but de l'invention est d'assurer une précision très élevée au niveau de la position de ou des inserts dans la partie métallique de la pièce en empêchant tout déplacement intempestif de ou des inserts dans le moule en photorésist avant et pendant la croissance de la couche métallique. Ce but est atteint par une méthode de fabrication de pièces nécessitant au moins l'assemblage de deux éléments, l'un obtenu par photolithographie et électroformage, et l'autre par un autre procédé de fabrication, cette méthode comprenant les étapes suivantes:
dépôt sur un substrat d'une couche de photorésist
irradiation, au travers d'un photomasque, de la couche de photorésist,
polymérisation de la couche de photorésist et élimination de la couche de photorésist non polymérisée, la partie de photorésist restante constituant un moule comportant un ensemble de microstructures et de cavités,
positionnement dans au moins une cavité d'au moins un élément rapporté obtenu par un autre procédé de fabrication en appui sur au moins un flanc d'une microstructure du moule en photorésist, au moins une portion de flanc de l'élément rapporté étant dégagée de la couche de photorésist dans la cavité du moule en photorésist,
croissance d'une couche métallique par électroformage sur le substrat et dans les cavités du moule de sorte que la couche métallique enserre tout ou partie de l'élément rapporté,
obtention d'une pièce comportant au moins un élément rapporté par élimination du substrat et du moule en photorésist,

la méthode est caractérisée en ce que, précédant la croissance de la couche métallique, au moins un point de colle est déposé sur la microstructure en photorésist et/ou sur l'élément rapporté et/ou sur le substrat, la colle assurant le positionnement et la fixation de l'élément rapporté.

## Description

### Domaine de l'invention

La présente invention concerne le domaine de la fabrication de micro-pièces métalliques par électroformage, en particulier des micro-pièces composées d'une partie métallique obtenue par photolithographie et électroformage et d'un ou plusieurs éléments rapportés insérés dans la partie métallique.

### Arrière plan technique

Le procédé de fabrication de micro-pièces ou composants par irradiation d'une couche photosensible aux rayons ultraviolets suivie d'une étape d'électroformage est connu et est décrit par exemple dans le brevet EP0851295B1.

Ce procédé est dérivé de la technique LIGA (Lithographie Galvanoformung Abformung) qui consiste à:
- déposer sur un substrat une couche de 1 à 2000 µm d'une résine photosensible (photorésist);
- effectuer à travers un masque une irradiation au moyen d'un synchrotron ou par une exposition de rayons ultraviolets;
- développer, c'est-à-dire éliminer par des moyens chimiques les portions de photorésist non polymérisées et créer de ce fait une cavité ou un moule en photorésist.
- électroformer un métal dans cette cavité afin d'obtenir une micro-pièce métallique.
- amener la couche métallique électroformée à une épaisseur prédéterminée par usinage mécanique et récupérer la micro-pièce après élimination du substrat et du photorésist.

L'avantage de cette technique est de réaliser des pièces ou composants mécaniques d'une très grande précision en X et Y et avec une épaisseur allant jusqu'à plusieurs millimètres. Il est également possible d'appliquer ce procédé en plusieurs étapes pour obtenir un composant en plusieurs niveaux, chaque niveau étant construit sur le précédent.

Ce procédé est décrit dans les documents EP1225477A1 ou EP1835339B1 qui détaillent le processus de masquage, d'irradiation et de dissolution de la partie non irradiée.

Cette technique est bien connue pour la fabrication de pièces pour l'horlogerie telles que par exemple des roues dentées, des cames, bascules ou ponts.

Une fois cette pièce produite par électroformage, elle est ensuite travaillée par un horloger pour y ajouter des éléments rapportés ou inserts tels que des pierres, paliers, galets et autres axes.

La particularité de ces inserts est de n'être pas réalisable par électroformage, soit pour des raisons de matière (pierre, rubis), soit pour des raisons de traitement de surface (trempage par exemple). C'est pourquoi ces inserts sont rapportés sur la pièce semi-finie par l'horloger, par enchâssement, sertissage, vissage ou autre emboutissage. Ces opérations sont délicates du fait de la petite taille des pièces en jeu et les faibles portées de soutien. Il arrive que lors de la pose d'une pierre, on détériore toute la pièce et les pierres déjà posées par un geste malheureux. A chaque opération, on ajoute de plus une imprécision résultant des tolérances de l'insert et de la pièce.

Une solution pour l'assemblage d'éléments décoratifs sur un substrat en utilisant une étape d'électroformage est décrite dans le brevet US3876511. Des éléments décoratifs sont posés sur la pièce à décorer et l'assemblage de ces éléments sur le support est effectué par électroformage, c'est-à-dire par un dépôt galvanique d'une couche métallique. Il s'agit ici d'une mise en place d'éléments décoratifs sur une pièce mécanique telle qu'un cadran de montre par exemple. Le positionnement de ces éléments décoratifs est approximatif et convient bien à une fonction purement esthétique.

Une autre solution est développée dans le brevet EP1916567B1 qui décrit une méthode dans laquelle un ou plusieurs inserts sont placés dans un moule obtenu par photolithographie d'une couche de photorésist déposée sur un substrat. Une couche métallique est déposée dans le moule en photorésist par électroformage de manière à enserrer tout ou partie de ou des inserts. Le moule est configuré pour guider et maintenir le ou les inserts pendant le dépôt de la couche métallique. La pièce obtenue après élimination du substrat et du moule se compose de deux éléments dont un premier élément métallique est issu de la couche métallique électroformée et un second élément composé d'un ou plusieurs inserts rapportés intimement liés au premier élément métallique. Cette liaison intime résulte de la croissance de la couche métallique le long des flancs de ou des inserts placés dans le moule en photorésist.

L'expérience a montré que cette solution peut présenter des défauts de stabilité et de tenue des inserts dans le moule en photorésist avant et pendant la croissance de la couche métallique par électroformage. En effet, avant et pendant cette phase de croissance de la couche métallique, des petits chocs, des vibrations ou des contraintes peuvent s'exercer sur les inserts entraînant un déplacement de ceux-ci dans la cavité du moule en photorésist et modifiant la précision de leur positionnement.

### Description sommaire de l'invention

Un but de l'invention est d'assurer une précision très élevée au niveau de la position de ou des inserts dans la partie métallique de la pièce en empêchant tout déplacement intempestif de ou des inserts dans le moule en photorésist avant et pendant la croissance de la couche métallique. Ce but est atteint par une méthode de fabrication de pièces nécessitant au moins l'assemblage de deux éléments, l'un obtenu par photolithographie et électroformage, et l'autre par un autre procédé de fabrication, cette méthode comprenant les étapes suivantes:
dépôt sur un substrat d'une couche de photorésist
irradiation, au travers d'un photomasque, de la couche de photorésist,
polymérisation de la couche de photorésist et élimination de la couche de photorésist non polymérisée, la partie de photoresist restante constituant un moule comportant un ensemble de microstructures et de cavités,
positionnement dans au moins une cavité d'au moins un élément rapporté obtenu par un autre procédé de fabrication en appui sur au moins un flanc d'une microstructure du moule en photorésist, au moins une portion de flanc de l'élément rapporté étant dégagée de la couche de photorésist dans la cavité du moule en photorésist,
croissance d'une couche métallique par électroformage sur le substrat et dans les cavités du moule de sorte que la couche métallique enserre tout ou partie de l'élément rapporté,
obtention d'une pièce comportant au moins un élément rapporté par élimination du substrat et du moule en photorésist,
la méthode est caractérisée en ce que, précédant la croissance de la couche métallique, au moins un point de colle est déposé sur la microstructure en photorésist et/ou sur l'élément rapporté et/ou sur le substrat, la colle assurant le positionnement et la fixation de l'élément rapporté.

Différentes solutions de collage permettent la réalisation de la méthode de l'invention, à savoir :
- Dans une première variante de l'invention, la colle lie l'élément rapporté et la microstructure par les faces supérieures horizontales.
- Dans une deuxième variante l'insert est fixé au substrat par la colle ajoutée sur le substrat ou la face inférieure de l'insert ; la microstructure n'étant dans ce cas utilisée que pour le positionnement de l'insert.
- Dans une troisième variante, la colle s'écoule par capillarité dans un espace situé entre au moins un flanc de la microstructure et au moins un flanc de l'élément rapporté. Cet écoulement de la colle entre les flancs est facilité par une forme spéciale de la microstructure en photorésist et/ou par une rugosité, porosité ou une forme spécifique de l'insert.

La croissance métallique sur le substrat et dans le moule enserre l'élément rapporté fixé par collage à la microstructure en photorésist et/ou le substrat. L'élément rapporté peut être par exemple une pierre d'horlogerie qui sera intégrée dans la partie métallique de la pièce finale. Les microstructures en photorésist ont pour but de positionner et de servir de points d'ancrage à l'élément rapporté avant la phase de croissance du métal dans les cavités du moule.

Lors de la phase finale de séparation du substrat de la couche métallique électroformée et de l'élimination du moule en photorésist, la colle est éliminée en même temps que le photorésist.

### Brève description des figures

L'invention sera mieux comprise grâce à la description détaillée qui va suivre en se référant aux dessins annexés dans lesquels :
La figure 1 montre les étapes essentielles du procédé selon l'invention en utilisant un moule de photorésist comportant un ensemble de microstructures contre un flanc desquelles un ou plusieurs inserts sont appuyés puis collés avant le dépôt d'une couche métallique dans les cavités du moule.
Les figures 2a, 2b et 2c montrent des détails de collage d'un insert contre une microstructure en photorésist.
Les figures 3a, 3b, 3c et 3d montrent un collage d'un insert comportant un orifice sur une microstructure en photorésist qui traverse l'orifice.
Les figures 4a, 4b, et 4c montrent une variante d'un collage d'un insert comportant un orifice sur une microstructure en photorésist à flancs rainurés qui traverse l'orifice.
Les figure 5a et 5b montrent une variante dans laquelle la couche métallique enserre les flancs et une partie de la face supérieure de l'insert comportant un orifice.
La figure 6 montre une pièce dans un moule à deux niveaux où l'insert est placé dans une cavité du premier niveau, la couche métallique étant électroformée dans le premier et le second niveau du moule.

### Description détaillée de l'invention

Le substrat 1 est constitué généralement d'une plaque de verre, de silicium ou de métal sur laquelle est déposée une couche conductrice réalisée par exemple par une évaporation de chrome et d'or. Sur cette couche conductrice est déposée puis séchée une couche photorésist sensible aux rayons ultraviolets (ou aux rayons X selon la technologie choisie).

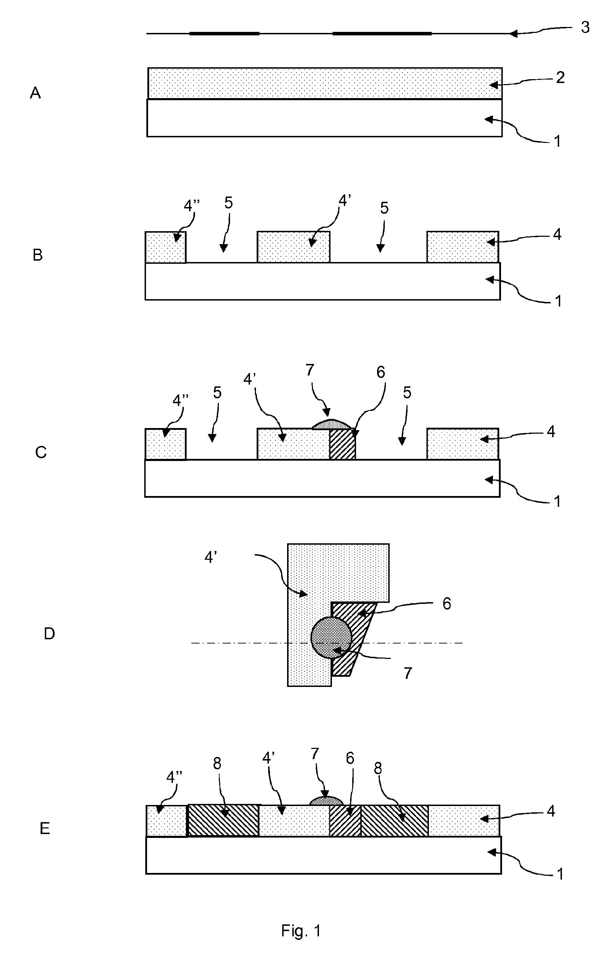

Cette couche de photoresist est ensuite irradiée par une source à ultraviolets ou à rayons X à travers une plaque en verre sur laquelle a été structuré un motif en chrome ou en or. Cette plaque avec sa découpe de chrome ou d'or est appelée un photomasque 3 utilisé à l'étape A illustrée par la figure 1.

La lumière arrivant parfaitement perpendiculairement sur le photomasque 3, seules les portions de photorésist non protégées par le motif en chrome ou en or seront irradiées. Les flancs des portions de photorésist ou microstructures sont ainsi perpendiculaires au substrat 1.

Dans le cas particulier d'une résine négative comme par exemple la résine du type SU8 ou ses dérivés, un recuit de la couche de photorésist provoque la polymérisation dans les zones ayant reçu le rayonnement UV. Cette partie polymérisée devient insensible à la plupart des solvants par opposition aux zones non irradiées qui sont dissoutes par un solvant.

L'étape A illustrée par la figure 1 consiste à déposer et irradier au travers d'un photomasque 3, une couche de photorésist 2 préalablement appliquée sur le substrat 1. Cette couche 2 de photorésist est polymérisée selon le motif du photomasque 3. A l'étape B, les parties de la couche non polymérisée sont éliminées par voie chimique et la partie de photorésist restante forme un moule comportant une ou plusieurs cavités 5 et un ensemble de microstructures (4, 4', 4") dont les formes correspondent au motif du photomasque 3.

A l'étape C un élément rapporté appelé également insert 6 est positionné dans la cavité 5 du moule sur le substrat 1 de manière à ce qu'au minimum une portion de flanc de l'insert 6 s'appuie contre un flanc d'une microstructure 4' et les portions restantes du flanc sont dégagées de la couche 2 de photorésist formant le moule et la microstructure.

Un point de colle 7 est ensuite déposé sur la microstructure 4' et/ou l'insert 6. Après durcissement de cette colle 7, l'insert 6 est maintenu dans une position fixe et stable durant les étapes ultérieures de fabrication de la pièce.

L'agrandissement D de la figure 1 montre une vue de dessus schématique d'un exemple dans lequel un flanc d'un insert 6 s'appuie contre un flanc de la microstructure 4'. Un point de colle 7 est déposé à cheval sur les flancs en contact.

A l'étape E, une couche métallique 8 croît par électroformage sur le substrat et dans les cavités 5 du moule de manière à enserrer l'insert 6 au niveau des flancs dégagés de la couche de photorésist 4 et à remplir entièrement la cavité 5.

La couche métallique 8 est de préférence usinée à une épaisseur prédéfinie et uniforme sur toute la surface de la couche. En effet, la surface brute d'une couche métallique électroformée est en général irrégulière et bombée par effet de « champignonnage » et de croissance inhomogène en épaisseur dû à la croissance du métal entre le substrat 1 et l'électrode ou les électrodes de l'outil de métallisation.

Lors d'une dernière étape, le photorésist polymérisé du moule et le substrat 1 sont enlevés complètement afin d'obtenir une pièce formée par la couche métallique 8 dont la forme et la structure sont définies par le photomasque 3 qui a servi à la réalisation du moule. Cette pièce comporte également l'insert 6 maintenu par le métal, la colle 7 qui a assuré le positionnement de l'insert 8 ayant été éliminée en même temps que le photorésist du moule.

L'élément rapporté ou insert 6 peut être de différentes matières telles que céramique (rubis, saphir, corindon, etc.), plastique, verre, métal, silicium, pierre taillée par exemple. Dans le cas d'une pose d'un élément rapporté réalisé en un matériau conducteur, une étape de dépose d'une couche isolante sur l'élément rapporté peut être réalisée telle que par exemple une laque. Cette opération peut être effectuée soit avant la pose de l'insert dans le moule, soit postérieurement, par un dépôt sélectif.

En fonction du composant micromécanique à réaliser, la hauteur de la microstructure (4, 4', 4") peut être égale comme dans le cas de la figure 1, inférieure ou supérieure à celle de l'insert 6.

Selon une variante, au moins un point de colle 7 peut être déposé sur l'insert 6 ou sur le substrat 1 avant la mise en place de l'élément rapporté 6. La colle 7 ainsi déposée fixe l'insert 6 au substrat (1), le positionnement de cet insert 6 étant assuré par une microstructure (4, 4', 4").

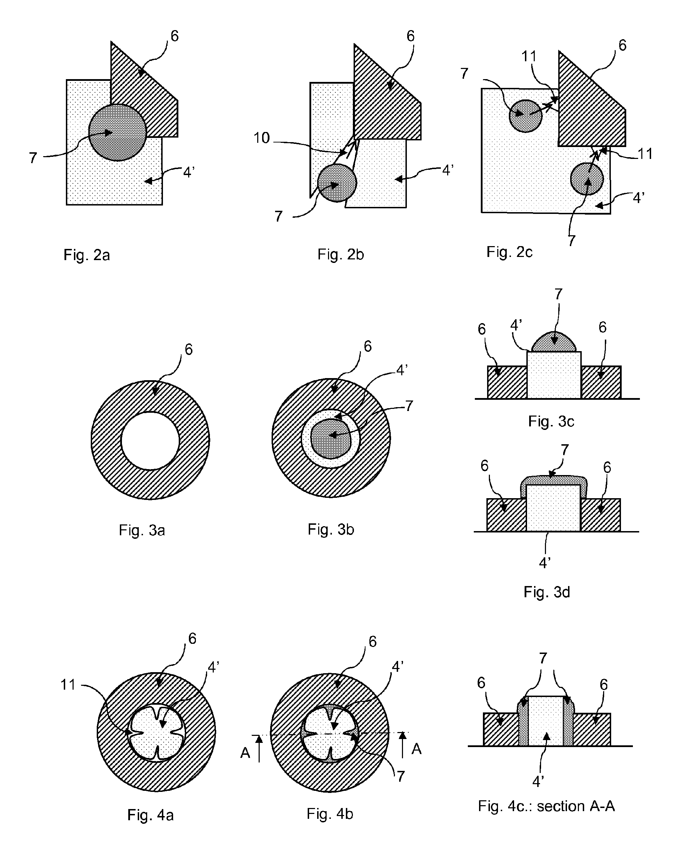

Les figures 2a, 2b et 2c illustrent d'autres exemples de microstructures contre lesquelles s'appuie un insert 6. La microstructure 4' comporte au moins deux flancs formant un angle concave s'adaptant à un angle convexe de l'insert 6 afin d'améliorer la stabilité de l'insert avant le dépôt de la colle 7. Dans l'exemple de la figure 2a, la colle 7 est amenée sur le dessus de la microstructure en photorésist 4' et de l'insert 6.

Dans le cas d'utilisation d'un insert 6 avec des flancs rugueux ou ayant un arrondi de polissage sur son arête, la colle 7 peut s'infiltrer entre les flancs en contact de la microstructure 4' et de l'insert 6. D'autres formes de microstructures dans lesquelles un insert peut s'emboîter en laissant un espace d'écoulement pour la colle sont également possibles.

Dans l'exemple de la figure 2b, la microstructure comprend au moins un canal 10 verticale dimensionnée de manière à conduire la colle par capillarité jusqu'aux flancs de contact entre l'insert et la microstructure. Ce genre de microstructure permet d'amener la colle sur le côté de la microstructure, sans toucher l'insert durant la dépose.

Dans l'exemple de la figure 2c, la microstructure 4' comprend plusieurs rainures 11 verticales qui ont pour rôle de conduire la colle 7 par capillarité le long du flanc de l'insert. Ce genre de microstructure 4' permet d'amener un point de colle sur le dessus de la microstructure 4' à proximité de chaque rainure, sans toucher l'insert 6 durant la dépose.

Lorsque l'insert 6 comporte un orifice traversant vertical comme illustré par les figures 3a, 3b, 3c et 3d, la géométrie de la microstructure 4' peut être adaptée de manière à pénétrer dans l'orifice. La colle 7 est déposée de préférence sur la microstructure 4' en quantité suffisante (Fig. 3b et 3c) de manière à faire déborder la colle 7 autour de la microstructure 4' et fixer l'insert 6 contre cette dernière (Fig. 3d). Dans le cas de l'utilisation d'un insert 6 avec une rugosité élevée sur ses flancs la colle 7 va également pouvoir être attirée par capillarité dans l'espace entre les flancs de l'insert 6 et ceux de la microstructure 4'.

Afin d'assurer une meilleure stabilité, les flancs de la microstructure peuvent comporter une pluralité de rainures 11 verticales pour faciliter l'écoulement de la colle le long des flancs de l'insert 6 comme dans l'exemple représenté par les figures 4a, 4b et 4c.

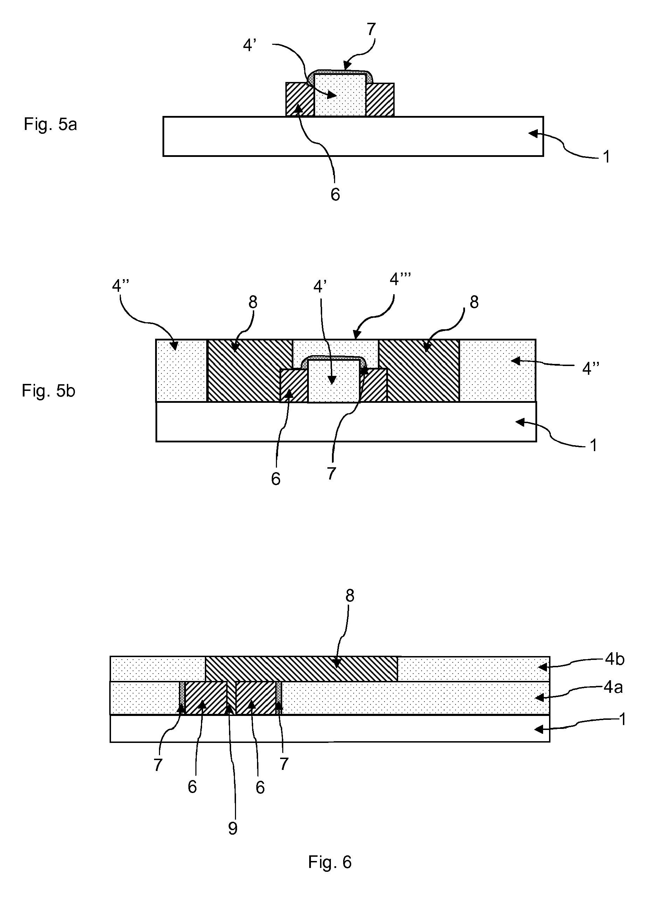

La couche métallique 8 peut enserrer l'insert 6 sur tout ou partie de son contour et sur tout ou partie de sa face supérieure comme représenté par la figure 5b. Les figures 5a et 5b illustrent une exécution avec un moule à deux niveaux nécessitant un premier photomasque pour réaliser les microstructures d'un premier niveau 4' servant au positionnement et au collage de l'insert 6 et un second photomasque servant à définir le moule de la pièce 4" et une microstructure 4"' délimitant le débordement du métal sur l'insert 6.

Selon un exemple de réalisation, l'insert 6 est constitué d'un écrou à filetage fin destiné à l'introduction d'une vis qui viendra buter sur la partie métallique. La réalisation d'une telle pièce de manière conventionnelle est très difficile car il faudrait usiner un trou borgne puis le fileter et cela sur des pièces de moins d'un millimètre d'épaisseur.

La variante de la figure 6 illustre un moule à deux niveaux dans lequel un insert cylindrique comportant un orifice 9 central traversant vertical est placé et collé dans une cavité du premier niveau. Dans cet exemple, l'insert est collé par ses flancs externes en contact avec les parois de la cavité de la couche de photorésist 4a du premier niveau comportant des rainures verticales 11, l'orifice 9 laissé vide est destiné à être rempli par la couche métallique 8 croissant également dans la cavité du second niveau formée dans la couche de photorésist 4b.

Le second niveau est obtenu par dépôt sur le substrat 1 d'une seconde couche de photorésist 4b recouvrant tout ou partie des microstructures et de l'insert 6. Cette seconde couche de photorésist 4b est irradiée à travers d'un second photomasque puis polymérisée, les parties non polymérisées étant éliminées. La partie restante de la couche de photorésist polymérisée forme des cavités d'un second niveau du moule. La couche métallique 8 croît dans le moule de depuis la surface du substrat 1 au fond de la cavité du premier niveau formée par l'orifice 9 de l'insert 6 jusqu'à remplir entièrement la cavité du second niveau en enserrant l'insert 6 à travers l'orifice 9 et sa face supérieure.

Dans l'exemple de la figure 6, l'insert 6 forme le premier niveau de la pièce tandis que la couche métallique 8 forme le second niveau. L'insert 6 est enserré par le métal électroformé dans l'orifice. L'insert 6 définit ainsi le contour extérieur d'une partie de la pièce finie avec une partie métallique intégrée à l'intérieur de l'insert 6. Selon un exemple, le matériau utilisé pour l'insert peut être du silicium dans lequel des parties métalliques seront électroformées.

Comme dans l'exemple de la figure 1, un usinage final de la surface supérieure de la couche métallique 8 électroformée est effectué avant l'élimination du moule en photorésist et du substrat.

Selon une variante, les deux niveaux du moule peuvent inclure chacun un ou plusieurs inserts. Dans ce cas, les inserts sont positionnés et collés à chaque niveau après réalisation du moule en photorésist polymérisé.

Selon une autre variante, le premier niveau du moule est obtenu par une combinaison de gravure profonde du substrat et de photolithographie de résine épaisse et le second niveau est obtenu par photolithographie de résine épaisse uniquement. Dans une première étape, une couche de photorésist est appliquée sur un substrat 1, par exemple en verre ou en silicium, et un premier photomasque est utilisé pour définir les contours du premier niveau. L'opération de gravure profonde du substrat est effectuée en général par gravure sèche (gravure plasma, par exemple DRIE, Deep Reactive Ion Etching) ou humide (par exemple gravure KOH, hydroxyde de potassium) impliquant une attaque chimique sélective des parties du substrat non protégées par un masque de gravure. De cette gravure profonde résulte une ou plusieurs cavités constituant le premier niveau du moule.

Selon une autre variante et dans le cas d'utilisation d'un substrat métallique, le premier niveau du moule est obtenu par une combinaison d'usinage du substrat et de photolithographie de résine épaisse servant à positionner au moins un insert.

L'étape suivante consiste à déposer une couche de photorésist épais. Un second photomasque est utilisé pour une polymérisation sélective. Le photorésist non polymérisé est ensuite dissous pour laisser apparaître la ou les cavités gravées dans le substrat et des microstructures en photorésist polymérisé disposées au fond de ou des cavités correspondant aux motifs du second photomasque. Cette couche de photorésist polymérisée forme le second niveau du moule.

L'insert est placé et collé sur au moins un flanc d'une microstructure par exemple comme illustré par les figure 1D, 2a, 2b, 2c ou comme illustré par les figures 3b, 3c, 3d, 4a, 4b et 4c lorsque l'insert comporte un orifice. La couche métallique est déposée dans le moule de manière à croître à partir du fond de ou des cavités du substrat en enserrant l'insert et dans le second niveau en photorésist.

## Revendications

1. Méthode de fabrication de pièces nécessitant au moins l'assemblage de deux éléments, l'un obtenu par photolithographie et électroformage, et l'autre par un autre procédé de fabrication, cette méthode comprenant les étapes suivantes:
dépôt sur un substrat (1) d'une couche de photorésist (2),
irradiation au travers d'un photomasque (3), de la couche de photorésist (2),
polymérisation de la couche de photorésist (2) et élimination de la couche de photorésist non polymérisée, la partie de photorésist restante constituant un moule comportant un ensemble de microstructures (4, 4', 4") et de cavités (5),
positionnement dans au moins une cavité (5) d'au moins un élément rapporté (6) obtenu par un autre procédé de fabrication en appui sur au moins un flanc d'une microstructure (4, 4', 4") du moule en photorésist, au moins une portion de flanc de l'élément rapporté (6) étant dégagée de la couche de photorésist dans la cavité (5) du moule en photorésist,
croissance d'une couche métallique (8) par électroformage sur le substrat (1) et dans les cavités (5) du moule de sorte que la couche métallique (8) enserre tout ou partie de l'élément rapporté (6),
obtention d'une pièce comportant au moins un élément rapporté (6) par élimination du substrat et du moule en photorésist,
la méthode est **caractérisée en ce que**, précédant la croissance de la couche métallique (8), au moins un point de colle (7) est déposé sur la microstructure en photorésist (4, 4', 4") et/ou sur l'élément rapporté (6) et/ou sur le substrat (1), la colle (7) assurant le positionnement et la fixation de l'élément rapporté (6).

2. Méthode selon la revendication 1 **caractérisée en ce que** la forme du contour de la microstructure (4, 4', 4") du moule en photorésist est configurée pour s'adapter sur au moins une portion du contour de l'élément rapporté (6) en laissant un espace facilitant l'écoulement de la colle par capillarité vers les flancs en contact de l'élément rapporté (6) et de la microstructure (4, 4', 4").

3. Méthode selon la revendication 1 **caractérisée en ce que** la microstructure (4, 4', 4") comprend au moins un canal (10) vertical dimensionné de manière à faciliter l'écoulement de la colle par capillarité jusqu'aux flancs de contact entre l'élément rapporté (6) et la microstructure (4, 4', 4"),

4. Méthode selon la revendication 1 **caractérisée en ce que** l'élément rapporté (6) comporte un orifice (9) traversant vertical, la géométrie de la microstructure (4, 4', 4") étant adaptée pour pénétrer dans l'orifice de sorte que la colle (7) déposée sur la microstructure (4, 4', 4") s'écoule par capillarité autour de la microstructure (4, 4', 4") et sur l'élément rapporté (6).

5. Méthode selon la revendication 1 **caractérisée en ce que** les flancs de la microstructure (4, 4', 4") comportent une pluralité de rainures (11) verticales destinées à faciliter l'écoulement de la colle (7) par capillarité entre les flancs en contact de l'élément rapporté (6) et de la microstructure (4, 4', 4").

6. Méthode selon la revendication 1 **caractérisée en ce que**, précédant l'étape de croissance de la couche métallique (8), au moins un point de colle (7) est déposé sur l'élément rapporté (6) ou sur le substrat (1) de sorte que la colle (7) fixe l'élément rapporté (6) au substrat (1), le positionnement de l'élément rapporté (6) étant assuré par la microstructure (4, 4', 4").

7. Méthode selon la revendication 1 **caractérisée en ce que** le moule en photorésist comporte au moins deux niveaux nécessitant un premier photomasque pour réaliser les cavités et/ou les microstructures d'un premier niveau et un second photomasque pour réaliser les cavités et/ou les microstructures d'un second niveau, le ou les éléments rapportés étant positionnés par leurs microstructures respectives après la réalisation d'un niveau ou dans le moule final.

8. Méthode selon l'une des revendications 1 à 7, **caractérisée en ce que** l'élément rapporté (6) se compose d'un matériau conducteur et **en ce qu'**elle comprend une étape de dépôt d'une couche isolante sur ledit élément rapporté (6) préalablement ou postérieurement au positionnement et collage dudit élément rapporté (6) dans le moule en photorésist.

9. Méthode selon l'une des revendications 1 à 8, **caractérisée en ce qu'**elle comprend une étape d'usinage de la couche métallique (8) à une épaisseur prédéterminée précédant la séparation du substrat (1) de la couche métallique (8) électroformée et l'élimination du moule en photorésist.

10. Méthode selon l'une des revendications 1 à 9, **caractérisée en ce qu'**elle comprend une étape d'usinage chimique ou mécanique d'au moins une cavité dans le substrat (1) destinée à positionner au moins un élément rapporté (6).
